# DEMANDE DE BREVET EUROPEEN

(11) **EP 0 531 186 A1**
(43) Date de publication de la demande: **10.03.1993**
(21) Numéro de dépôt: 92402276.7
(22) Date de dépôt: 12.08.1992
(51) Int. Cl.: B60Q 1/26, F21Q 1/00, H01L 25/075

(54) **Feu de signalisation à éléments électroluminescents, notamment pour véhicule automobile**

(30) Priorité: 02.09.1991 FR 9110839
(71) Demandeur: VALEO VISION, 93012 Bobigny Cédex (FR)
(72) Inventeur: Louy, Jean-François, F-75016 Paris (FR); Mouroy, Bernard, F-77680 Roissy-en-Brie (FR)
(74) Mandataire: Lemaire, Marc

(57) **Abrégé**

Le feu de signalisation comporte un élément optique de collimation (2), des éléments électroluminescents (3) comprenant chacun des bornes d'alimentation (34,35) et un émetteur de lumière proprement dit à semi-conducteur, un élément de support (4) pour support des éléments électroluminescents (3), ledit élément de support (4), d'une part, présentant une face frontale (49) pour appui des éléments électroluminescents et une face dorsale (41), et d'autre part, portant un circuit électrique d'alimentation et d'interconnexion (5) pour lesdites bornes d'alimentation, l'élément du support (4) a une forme non plane et est conformé pour présenter des moyens de montage suivant une même direction inclinée donnée pour les éléments électroluminescents (3).

## Description

La présente invention concerne d'une manière générale les feux de signalisation, notamment pour véhicule automobile.

Un feu de signalisation de conception classique se présente sous la forme d'un bloc comprenant au moins un réflecteur dans lequel est montée une lampe à incandescence ou fluorescence, une glace transparente ou globe étant montée devant le réflecteur.

Un tel feu est relativement épais et pose des problèmes d'adaptation au support sur lequel il doit être monté, notamment la région du coin du véhicule ou une aile de celui-ci.

D'une manière générale, les ampoules sont fragiles, ont une durée de vie relativement courte, et sont consommatrices d'énergie.

Pour cette raison, on a déjà proposé des feux de signalisation utilisant comme source lumineuse un ensemble d'émetteurs de lumière à semi-conducteur, tel que des diodes électroluminescentes.

Ces réalisations offrent la possibilité de disposer, par exemple, des diodes éclairantes dans les deux couleurs, rouge et orange, utilisées pour la signalisation automobile, tout en étant incolores à l'état éteint ce qui permet d'obtenir un feu d'aspect régulier, à l'état éteint.

Un tel feu de signalisation est montré par exemple dans le document FR-A-2 545 195 (GB-A-2 139 340), qui décrit une réalisation avec des diodes portées à solidarisation par une plaque de support conformée pour recevoir dans des cavités des micro-plaquettes de diodes électroluminescentes et pour présenter un circuit électrique de connexion entre les micro-plaquettes.

Ces micro-plaquettes sont recouvertes d'une couche protectrice. Il y a donc formation d'une matrice de micro-plaquettes de diodes avec scellement commun et verre diffusant commun.

Tout ceci conduit à doter la plaque de support, formant élément de support, et la couche protectrice d'un dépôt en couche d'aluminium réfléchissante.

Il en résulte une construction relativement complexe et onéreuse nécessitant un outillage complexe, des salles conditionnées et de grands investissements. Cette disposition n'est donc pas envisageable par un fabricant de feu de signalisation.

Pour simplifier l'élément de support (la plaque) on peut songer, comme divulgué dans les documents FR-A-2 481 563, FR-A-2 601 486 (EP-A-0 253 244) et FR-A-2 574 616 (US-A-4 742 432), à utiliser des éléments électroluminescents discrets comportant un support portant des bornes d'alimentation et un émetteur de lumière à semi-conducteur.

Ainsi, l'élément de support n'a pas besoin d'être doté de cavités réfléchissantes. Il se pose un nouveau problème de montage. En effet, si l'on associe un élément optique de collimation à l'élément de support, comme divulgué dans le document FR-A-2 574 616 (US-A-4.742.432), on doit monter ledit élément optique en final sur l'élément de support portant les éléments électroluminescents déjà fixés sur celui-ci, pour notamment un montage aisé de ceux-ci.

C'est donc avec jeu que l'on monte l'élément optique de collimation sur les éléments électroluminescents, ledit élément optique présentant des cavités paraboliques avec des ouvertures isolantes s'engageant à faible jeu sur des anneaux conducteurs des éléments électroluminescents.

Les éléments électroluminescents peuvent donc, pour certains, ne pas être disposés dans l'axe optique de la parabole au détriment des peformances du feu.

En outre, lorsque le feu a une forme gauche, par exemple bombée, le montage devient très difficile.

D'une manière générale il faut veiller à ne pas perdre des éléments électroluminescents car l'ensemble élément de support - éléments électroluminescents est difficilement manipulable et transportable avant assemblage des éléments électroluminescents avec leur circuit électrique.

La présente invention a pour objet de pallier ces inconvénients et donc de créer un nouveau feu de signalisation à élément de support simplifié, tout en continuant à bénéficier d'un assemblage économique et aisé des éléments électroluminescents avec leur circuit électrique d'alimentation associé et en ayant de bonnes performances optiques quelle que soit la forme du feu.

Suivant l'invention, le feu de signalisation comporte un élément optique de collimation, des éléments électroluminescents comprenant chacun des bornes d'alimentation et un émetteur de lumière proprement dit à semi-conducteur, un élément de support pour support des éléments électroluminescents, ledit élément de support, d'une part, présentant une face frontale pour appui des éléments électroluminescents et une face dorsale et, d'autre part, portant un circuit électrique d'alimentation et d'interconnexion pour lesdites bornes d'alimentation, est caractérisé en ce que, en combinaison l'élément de support a une forme non plane et en ce que l'élément de support est conformé pour présenter des moyens de montage suivant une même direction inclinée donnée pour les éléments électroluminescents.

Grâce à cette disposition, il est possible de procéder à un montage automatique encore plus rapide des éléments électroluminescents sur leur élément de support à l'aide d'un robot simplifié, puisque tous les éléments électroluminescents sont montés suivant la même direction. Cette disposition permet d'éviter un montage manuel fastidieux tout en ayant un robot simplifié et économique à une seule direction de montage.

Avantageusement, suivant l'invention, un feu de signalisation du type sus-indiqué est caractérisé en ce que les éléments électroluminescents sont pris en sandwich entre l'élément de support et l'élément optique de collimation lié audit élément de support par des moyens de fixation.

Grâce à l'invention, il est possible de monter, avec jeu, les éléments électroluminescents sur leur élément support sans les fixer, puis d'assembler l'élément optique de collimation audit élément de support en sorte qu'il est formé un ensemble élément optique de collimation - éléments électroluminescents - élément de support manipulable transportable et aisément stockable.

On appréciera, d'une part, que l'élément optique de collimation protège les éléments électroluminescents sous forme de composants électroniques économiques de grande série et, d'autre part, qu'il permet un bon positionnement des éléments électoluminescents (dans les axes optiques) avant leur fixation avec l'élément de support et quelle que soit la forme du feu.

Il est donc possible de fabriquer cet ensemble dans un lieu donné, puis de le transporter, sans perte d'éléments électroluminescents, dans un autre lieu, pour assemblage des bornes électriques des éléments électroluminescents avec leur circuit électrique associé et ce en ayant un feu de grande performance optique.

On appréciera que cette opération est aisée puisque les éléments électroluminescents sont emprisonnés. Il est même possible de retourner le feu et/ou les bornes des diodes pour fixer d'autres composants optiques électroniques sur la face dorsale de l'élément de support. La fabrication du feu est donc économique et simple.

On appréciera également la compacité axiale dudit ensemble, ainsi que sa possibilité de se conformer aisément au support sur lequel il doit être monté, tel que la région du coin du véhicule ou une aile de celui-ci.

Grâce à l'invention, l'élément de support peut présenter facilement des moyens de fixation pour fixation du feu de signalisation au support sur lequel il doit être monté.

Cet élément de support peut également porter un joint d'étanchéité à la faveur d'un rebord et être avantageusement revêtu par un élément transparent. Ce joint d'étanchéité assure ainsi une protection étanche des bornes et du circuit électrique entre la face dorsale de l'élément porteur et la carrosserie. Le rebord de l'élément de support peut être conformé pour épouser la forme de la carrosserie du véhicule et assurer ainsi par coopération de formes une étanchéité.

La disposition selon l'invention favorise le montage automatique des éléments électroluminescents ainsi que la réduction des temps de montage.

En effet, grâce à l'invention, c'est l'élément optique de collimation qui replace et positionne précisément les éléments électroluminescents en sorte que ceux-ci n'ont pas besoin d'être positionnés très précisément.

Par exemple, l'élément électroluminescents peut présenter des bornes sous forme de pattes traversant à jeu des passages formés dans l'élément porteur, ledit jeu favorisant le montage automatique. L'élément électroluminescent peut donc présenter un grand nombre de formes sans gêne pour un montage automatique.

Avantageusement, l'élément optique de collimation est conformé en guide de lumière et présente des trous de forme adéquate en correspondance avec l'émetteur de lumière des éléments électroluminescents.

Cet élément optique de collimation peut donc avoir une forme simple, sa fabrication par moulage étant aisée, et il en est de même pour l'élément de support.

Un élément transparent recouvre avantageusement l'élément optique de collimation. Il peut être de teinte uniforme, par exemple fumé, ou présenter plusieurs couleurs suivant les souhaits du conducteur. Cet élément transparent peut assurer une fonction optique ou non.

Ainsi, suivant une autre caractéristique, en cas d'inclinaison, on conforme alors l'élément transparent de telle manière qu'il puisse assurer le redressement des rayonnements inclinés générés par les éléments électroluminescents en coopération avec l'élément optique de collimation, jusque dans une direction moyenne à la direction axiale du véhicule et à la diffusion de ce rayonnement autour de cette direction moyenne en vue de satisfaire aux règlements en matière de photométrie.

D'autres aspects, buts et avantages de l'invention apparaîtront mieux à la lecture de la description qui va suivre et en référence aux desssins annexés dans lesquels:
- la figure 1 est une vue en coupe horizontale du feu de signalisation selon l'invention;
- la figure 2 est une vue à plus grande échelle d'une partie de la figure 1;
- la figure 3 est une vue partielle montrant l'assemblage de l'élément optique de collimation avec l'élément de support du feu de signalisation;
- les figures 4 et 5 sont des vues analogues à la figure 3 respectivement pour un deuxième et un troisième modes d'assemblage de l'élément optique de collimation avec son élément de support;
- la figure 6 est une vue partielle montrant une deuxième variante des moyens d'orientation pour montage des éléments électroluminescents;
- les figures 7 et 8 sont des vues de face simplifiées respectivement de l'élément optique de collimation et de l'élément transparent.

Dans cette description on entend par élément isolant un élément électriquement isolant tel que les éléments 33, 2, 4 décrits ci-après.

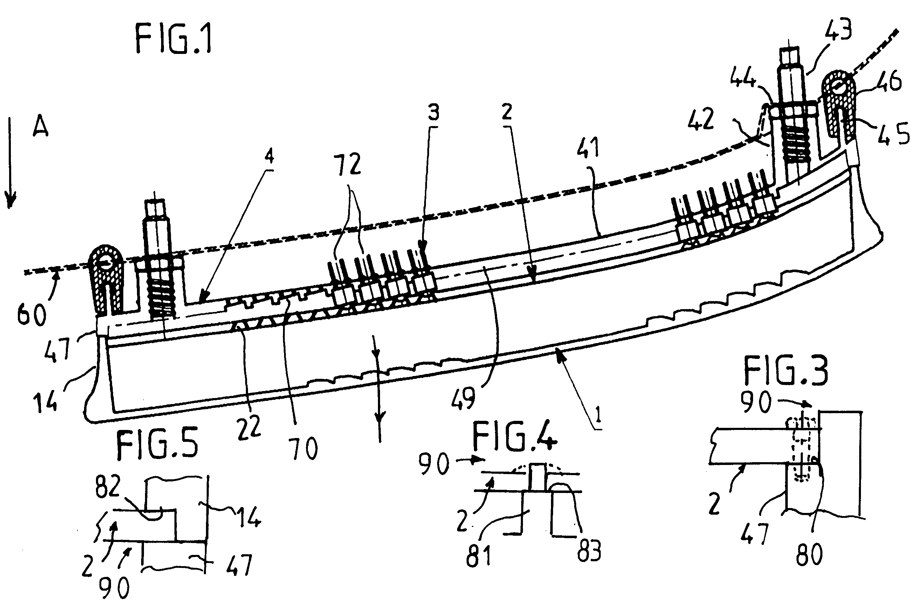

En référence à la figure 1, un feu de signalisation selon l'invention comporte un élément transparent 1, un élément optique de collimation 2, des éléments électroluminescents 3 et un élément de support 4 desdits éléments électroluminescents. Comme représenté, le feu a une forme gauche et l'élément de support 4 a une forme non plane.

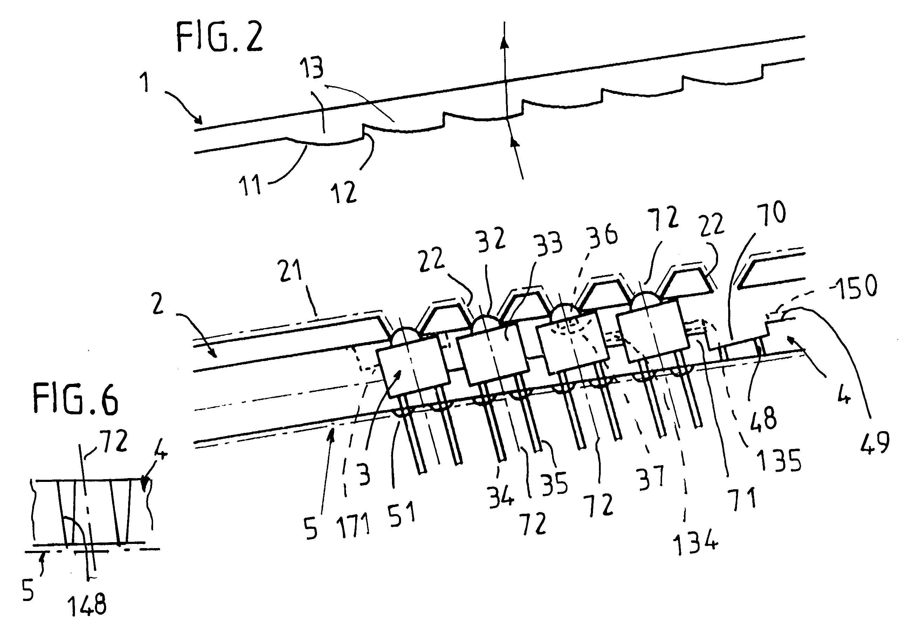

Ici chaque élément électroluminescent 3 (figure 2) comporte un support 33 portant en saillie sur l'une de ses faces des bornes d'alimentation 34, 35 (anode - cathode) et sur l'autre de ses faces, un encapsulage 32, ici à forme pénétrante, entourant un émetteur de lumière proprement dit 36 à semi-conducteur, tel qu'un cristal, porté par ledit support 33. Les bornes peuvent être enrobées ou non par le support 33 généralement isolant.

L'élément de support 4 présente des passages 48 pour montage desdites bornes 34, 35 qui traversent, ici suivant une caractéristique de l'invention à jeu, lesdits passages 48 et l'élément de support 4. A chaque élément 3 est donc associé un nombre de passages 48 correspondant au nombre de bornes 34,35.

Cet élément de support 4, ici opaque, isolant et de forme gauche, porte sur sa face dorsale 41 (celle tournée vers la carrosserie 60 du véhicule) un circuit électrique 5 d'alimentation pour lesdites bornes d'alimentation 34, 35, ledit circuit 5 réalisant une interconnexion entre lesdites bornes 34,35 pour alimentation électrique desdits éléments électroluminescents 3.

On notera que la forme gauche de l'élément de support entraîne la formation d'un réseau tridimensionnel d'éléments discrets électroluminescents 3.

De manière connue en soi, ce circuit 5 est connecté à un connecteur d'alimentation alimenté par un faisceau électrique du véhicule.

Les éléments électroluminescents 3 sont pris en sandwich entre l'élément de support 4 et l'élément optique de collimation 2 lié audit élément de support 4 par des moyens de fixation 90.

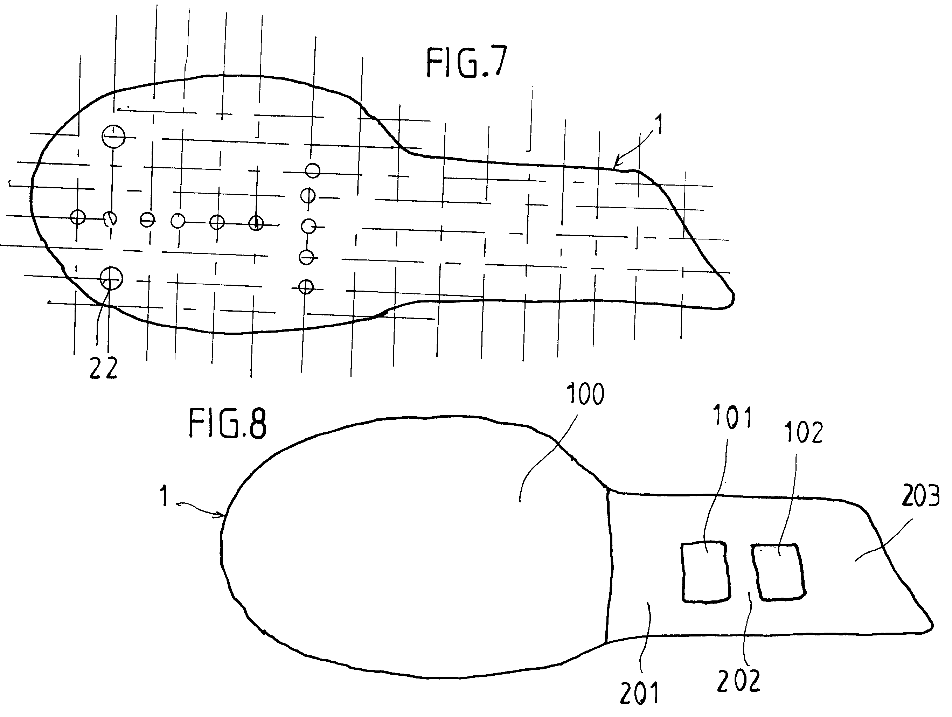

Plus précisément, les éléments électroluminescents 3 consistent ici en des "Brewster" fabriqués en grande série par la firme Hewlett-Packard. Ces "Brewster" comportent un support 33 isolant, qui est ici plus large que l'encapsulage 32, constituant en quelque sorte l'oeil de l'élément électroluminescent 3. Les "Brewster" forment un réseau tridimensionnel en forme de matrice avec des lignes et des colonnes de "Brewster", une ligne de "Brewster" étant visible à la figure 1, tandis qu'à la figure 7 on voit les axes du réseau avec certaines ouvertures 22 de l'élément 2 décrit ci-après. Ici les bornes 34,35 consistent en des languettes conductrices.

Bien entendu, on peut utiliser des diodes électroluminescentes comme décrit par exemple dans les documents FR-A-2 481 563, EP-A-0 362 993 (US-A-4964025 et US-A-5001609) ou FR-A-2 601 486 (EP-A-0 253 244).

Le support 33 est porté par la face frontale 49 de l'élément de support 4, tournée vers l'extérieur à l'opposé de sa face dorsale 41 et de la carrosserie 60. La face dorsale 41 de cet élément porteur 4 est revêtue par le circuit électrique 5 réalisé ici de préférence par sérigraphie ou en variante par dépôt électrochimique ou électrolytique. On peut également réaliser le circuit électrique à l'aide d'un film souple rapporté par collage sur la face dorsale 41 au moyen d'une pellicule adhésive, ledit film portant un revêtement cuivré et étamé. Ainsi, ici, la face frontale 49 sert d'appui aux éléments électroluminescents 3 en étant dépourvus de tout circuit électrique.

De place en place, la face dorsale 41 porte des moyens de fixation pour fixation du feu de signalisation au support sur lequel il doit être monté. Ici les moyens de fixation comportent des goujons 43 montés dans des canons 42 solidaires de l'élément de support 4, un écrou 44 étant également prévu pour montage sur la carrosserie 60 du véhicule.

En variante, il peut s'agir de pattes de fixation trouées pour passage d'organes de fixation (des vis par exemple) ou de pattes élastiques en forme de crochet pour montage par clipsage du feu dans des ouvertures correspondantes de la carrosserie. La face dorsale 41 porte également une nervure périphérique 45 pour montage d'un joint d'étanchéité 46 entre ledit feu et la carrosserie 60.

Cet élément de support 4 est de forme creuse et présente une paroi périphérique ou rebord 47 délimitant le contour de cet élément 4 en s'érigeant vers l'extérieur (en direction opposée à la nervure 45)à partir du fond de celui-ci constitué par l'élément porteur proprement dit, ledit fond présentant les passages 48.

Ici, cet élément de support ou porteur 4 est avantageusement en matériau électriquement isolant, en pratique de la matière plastique, et a une forme bombée non plane adaptée à la forme de la carrosserie 60. Il est fabriqué de manière simple par moulage comme l'élément 2 décrit ci-après, les canons 42, la nervure 45 et le rebord 47 étant d'un seul tenant avec l'élément 4 proprement dit. On appréciera que la nervure 45 est de hauteur telle (voir figure 1) qu'elle assure une protection des bornes 34, 35 et éventuellement d'autres composants électroniques avant enfilage du joint 46. Ainsi, l'élément de support 4 a une fonction supplémentaire de protection grâce à sa nervure ou paroi périphérique 45 plus haute que les bornes 34, 35.

Une fois monté sur véhicule le joint 46, avec la nervure 45, en combinaison avec la carrosserie 60 assure une étanchéité du circuit électrique 5 et des bornes 34, 35 au bénéfice d'une bonne longévité et fiabilité du feu.

Bien entendu la nervure 45 peut être profilée pour être montée dans un renforcement de la carrosserie 60 et assurer elle-même ainsi par coopération de formes l'étanchéité des bornes 34, 35 et du circuit électrique 5.

L'élément 4 est opaque et est, selon l'invention, conformé pour présenter des moyens de montage 70, 71 suivant une direction inclinée donnée pour les éléments électroluminescents 3. Ici, les moyens de montage forment donc des moyens d'orientation suivant une direction donnée et présentent des portées d'appui 70 ainsi que des nervures de positionnement 71 s'érigeant en saillie par rapport aux portées 70. Les portées 70 et les nervures 71 sont formées sur la face frontale 49.

Les passages traversants 48 débouchent, ici symétriquement par rapport à un axe 72, au niveau de chaque portée 70. Ces portées 70 sont toutes perpendiculaires à une direction commune définie par les axes 72 parallèles entre eux, tandis que chaque passage 48 est parallèle audit axe 72. Il en est de même des parois longitudinales des nervures 71, qui sont perpendiculaires aux portées 70.

Les axes 72 sont donc inclinées par rapport à la direction axiale A du véhicule en constituant des axes de symétrie pour les portées 70 et les supports 33 des éléments 3.

On appréciera que les portées 70 délimitent, ainsi que les nervures 71, formant un quadrillage, la face frontale 49 de l'élément porteur 4.

Ces nervures 71 sont donc adaptées à la forme des supports 33 pour coopérer, ici suivant une caractéristique à jeu, avec ceux-ci, les supports 33 pouvant être de forme cylindrique ou parallélépipédique.

Les portées 70 sont toutes parallèles entre elles.

Seule l'épaisseur de l'élément porteur 4 varie d'une portée 70 à une autre en fonction de la forme (du galbe) du feu de signalisation.

Chaque élément électroluminescent peut être monté automatiquement, dans une même direction inclinée, à l'aide d'un robot simple sur la portée 70 en étant prépositionné par les nervure 71, avantageusement à arêtes internes chanfreinées, le fond du support 33 de chaque élément 3 étant en contact avec la portée 70 tandis que les parois latérales dudit support 33 sont entourées en partie par les nervures 71, dont le contour est adapté à celui du support 33.

Les nervures 71 permettent donc de bien prépositionner les supports 33 et évitent que les éléments électroluminescents tombent d'eux-mêmes par simple gravité. Elles maintiennent les éléments 3 et évitent que ceux-ci ne se couchent en sorte que les éléments 3 peuvent constituer par eux-mêmes des entretoises entre les éléments 2 et 4 et que le feu peut être très courbé. Les temps de montage sont donc de faible durée et le robot a des temps d'immobilisation courts. De plus, ce montage est aisé puisque les bornes 34, 35 traversent à jeu les passages 48 et qu'un jeu existe entre les nervures et le support 33.

Grâce à l'invention, l'élément optique de collimation 2 consite ici en un réflecteur conformé en guide de lumière. Plus précisément cet élément optique de collimation présente en regard de chaque encapsulage 32, une ouverture 22 évasée de diffusion de la lumière, l'encapsulage 32 émetteur de lumière étant en quelque sorte placé au foyer de l'ouverture 22 qui est plus élargie au niveau de sa face frontale tournée vers l'élément 1. Au niveau de la face dorsale de l'élément 2, les ouvertures 22 ont une taille adaptée à celle de l'encapsulage 32.

Cet élément optique 2 consiste en une plaque bombée en matière isolante dont la face frontale est revêtue d'un revêtement réfléchissant 21 ainsi que l'alésage interne des ouvertures 22 traversantes. Les ouvertures 22 forment un réseau tridimensionnel d'ouvertures 22 à l'image du réseau d'éléments électroluminescents 3.

Ici, cet élément 2 a une forme gauche qui est à l'image de celle de l'élément 4 et est en matière plastique opaque revêtue d'un revêtement réfléchissant en aluminium 21. L'élément 2 surplombe les portées 70, les nervures 71 en sorte qu'il forme globalement un couvercle pour l'élément 4.

On appréciera que tout comme l'élément de support 2 la fabrication dudit élément 2 est aisée, le démoulage de ces ouvertures 22 ne posant pas de problème. Ces ouvertures 22 peuvent avoir une forme quelconque dépendant des applications et de la position de l'ouverture sur le feu. Leur forme peut être calculée par ordinateur, leur angle d'ouverture variant selon leur position, ainsi que l'inclinaison de leur axe.

Compte tenu de l'inclinaison des axes 72 par rapport à la direction A, l'élément transparent, ici en matière plastique transparente, est réalisé de façon à assurer aussi simplement et économiquement que possible à la fois le redressement des rayons lumineux inclinés, produits par les éléments électroluminescents 3 et l'élément optique de collimation 2, jusqu'à dans une direction moyenne essentiellement parallèle à la direction axiale A du véhicule et à la diffusion de ces rayons lumineux autour de cette direction moyenne en vue de satisfaire aux règlements en matière de photométrie.

A cet effet, la surface interne de cet élément transparent 1 présente une succession d'éléments du genre prismatique 13 comportant des surfaces inclinées 11 séparées par des dépouilles 12.

Les surfaces inclinées 11 sont des surfaces d'entrée de la lumière et sont divisées en pavés inviduels de surface convexe.

L'inclinaison de surface d'entrée de ces pavés assure, en l'espèce par réfraction, le redressement des rayons lumineux ou rayonnement pour amener ledit rayonnement dans une direction moyenne parallèle à la direction A, tandis que la forme bombée des pavés élémentaires assure, simultanément une diffusion contrôlée de ce rayonnement.

En variantes, on peut utiliser des pavés individuels à surface concave ou des éléments prismatiques.

Bien entendu, le redressement du rayonnement peut être réalisé avec deux couches de matière transparente ou translucide d'indices différents, des billes de diffusion ou analogues étant prévues dans l'une des couches.

L'élément transparent 1 est de forme gauche, bombée et creuse, à l'image des éléments 2, 4 et présente également un rebord périphérique 14 propre à coopérer avec le rebord 47 de l'élément de support 4. L'élément 1 surplombe donc l'élément 4 ainsi que l'élément 2 et son rebord 14 est ici solidarisé de manière étanche avec le rebord 47, les rebords 14 et 47 assurant un écartement entre l'élément transparent 1 et l'élément optique de collimation 2. Tout ceci favorise une bonne évacuation de la chaleur engendrée par les éléments 3.

Les moyens de fixation 90 comportent un décrochement 80 formé à la périphérie externe du rebord 47.

L'élément 2 est destiné par sa face dorsale à venir en appui contre la partie horizontale dudit décrochement ainsi que par sa face latérale à venir en contact avec la partie verticale dudit décrochement pour prépositionnement de l'élément 2 à jeu dans l'élément 4.

Le décrochement 80 constitue donc un épaulement pour l'élément 2. Ainsi, en partant d'un élément porteur 4 revêtu de son circuit électrique 5, le montage s'effectue de la manière suivante :
1°) on enfile, selon la direction définie par les axes parallèles 72, du côté de la face frontale 49 de l'élément 4, les éléments électroluminescents 3 à jeu dans les passages 48 à l'aide d'un robot, ledit robot permettant un enfilage automatique des bornes 34, 35 dans les passages traversants 48 jusqu'à ce que les faces dorsales des supports 33 viennent en contact avec les portées d'appui 70, lesdits supports 33 rencontrant d'abords les nervures 71 en étant guidés par celles-ci.
2°) on procède ensuite à un montage de l'élément optique de collimation 2 par enfilage de ses ouvertures 22 sur les encapsulages 32 des éléments 3, puis on fixe l'élément 2 par rapport à l'élément porteur 4.
3°) on fixe ultérieurement les bornes 34, 35 sur leur circuit 5.

On appréciera, suivant une caractéristique importante de l'invention, que l'élément 2, avant sa fixation sur l'élément 4, assure un recentrage des "Brewster" 3.

En effet, ainsi qu'il ressort de la description, lors de l'enfilage, les ouvertures 22 coopèrent avec les encapsulages 32 à forme pénétrantes, ici en forme d'ogive ou en forme de demi-olive, en sorte que les éléments 33, montés à jeu dans les nervures 71 et les passages 48, prennent automatiquement la bonne position. Ils prennent donc la position idéale pour former le foyer du centre optique du système optique. Les performances optiques du feu sont donc excellentes même si celui-ci , comme ici, a une forme gauche.

Grâce à la forme pénétrante des encapsulage 32 aucun jeu ne peut exister entre l'extrémité dorsale des ouvertures 22, adaptée aux dimensions des encapsulages 32, et lesdits encapsulages au bénéfice d'un bon rendement optique.

Comme visible à la figure 3 la fixation de l'élément 2 peut se faire à l'aide de vis venant se visser dans le rebord 47 à la faveur de la partie horizontale du décrochement 80, l'élément 2 étant monté à jeu dans le décrochement 80.

Cette disposition permet un démontage ultérieur de l'élément 2. En variante au lieu d'une fixation par vissage on peut réaliser une fixation par collage à l'aide de points de collage.

En variante, figure 4, les moyens de fixation 90 peuvent comporter des tétons étagés 81 issus en saillie de l'élément 4 avec formation d'un épaulemnt 83, l'extrémité libre desdits tétons traversant l'élément 2 pour un assemblage par thermo-sertissage.

L'élément 2 est alors engagé sur l'extrémité libre des tétons en contact avec l'épaulement 83 puis on procède ultérieurement à l'échauffement et à l'écrasement de la tête saillante du pion 81 pour immobilisation de l'élément 2 par sertissage entre l'épaulement 83 et ladite tête. En variante on peut procéder à un assemblage par clipsage, l'élément 4 présentant des pattes élastiques à extrémité en forme de crochet venant s'encliqueter dans des ouvertures de l'élément 2.

Il est ainsi constitué un ensemble manipulable et transportable comportant les éléments 2, 3 et 4, les éléments 3 étant coincés par leur support 33 entre l'élément 2 et l'élément 4.

En se reportant à la figure 2, ont voit que les éléments 3 constituent par leur support 33 des entretoises entre les éléments 4 et 2. Un faible jeu est avantageusement ménagé entre l'élément 2 et la partie horizontale du décrochement 80 de la figure 3 ou entre ledit élément 2 et l'épaulement 83 de la figure 4.

Bien entendu, les éléments 3 peuvent être emprisonnés avec un léger jeu entre les éléments 4 grâce à leur support 33. Quoi qu'il en soit les éléments 3, pris en sandwich, ne peuvent s'échapper en sorte que l'on puisse manipuler aisément l'ensemble des pièces 1, 2 et 3 de manière à avoir accès à la face dorsale 41, éventuellement par retournement de l'élément 4, pour procéder à un soudage, visible en 51 à la figure 2 des bornes 34, 35 sur leur circuit électrique associé 5 étamé à cet effet.

Cette opération de soudure peut être faite à la vague, à l'aide par exemple d'un bain d'étain en mouvement, ou dans un four de refusion de la pâte collante, avec de l'étain, étant auparavant posée sur les bornes 34, 35. En variante, on peut utiliser de la colle conductrice polymérisable ou utiliser une fixation par chauffage par induction ou micro-onde. Quoi qu'il en soit, l'élément 4 étant retourné ou pas, l'interposition selon l'invention des éléments 3 entre les éléments 2 et 4 permet une bonne opération de soudage.

On appréciera que la réalisation par sérigraphie du circuit 5 d'interconnexion par dépôt d'encre conductrice sur l'élément de support, permet un montage aisé des bornes 34, 35, le circuit 5 ne risquant pas de se soulever lors de l'enfilage des bornes 34, 35 à jeu dans les passages 48. Il en est de même lorsque le circuit électrique est réalisé à l'aide d'un film souple collé sur la face dorsale 41 et traîné en regard des passages 48 ou est réalisé par dépôt électrolytique ou électrochimique comme explicité ci-dessus. Avantageusement, les trous du circuit électrique pour passage des bornes 34, 35 ont une taille supérieure à celle des passages 48.

Une fois la fixation des éléments 3 réalisée on vient fixer l'élément transparent 1 de manière étanche par son rebord 14 sur le rebord 47 de l'élément 4. Cette fixation étanche peut être réalisée par collage, soudage à chaud ou soudage par ultrasons permettant une étanchéité parfaite entre l'élément 4 et l'élément 1.

Bien entendu, la présente invention n'est pas limitée à l'exemple de réalisation représenté, en particulier comme visible à la figure 5, la fixation de l'élément optique de collimation 2 peut être réalisée par coincement de son bord entre les rebors 14 et 47 respectivement des pièces 1 et 4.

En variante, la fixation peut se faire par clipsage, le rebord 14 portant des pattes élastiques à crochet traversant des ouvertures de l'élément 4 pour crochetage. Le rebord 14 peut être conformé profilé et peut coopérer avec un renforcement de la carrosserie 60 et assurer une étanchéité du feu par coopération de forme avec ledit renforcement. Dans ce cas le rebord 14 enveloppe l'élément 4.

On appréciera que dans tous les cas, les encapsulages des éléments électroluminescents 3 sont protégés soit par l'élément 2 ou soit par l'élément 1 avant fixation des bornes 34, 35 sur leur circuit 5.

En variante, les portées d'appui 70 peuvent être remplacées par des passages évasés 148 (figure 6).

Ces passages 148 sont en partie parallèles aux axes 72, les bornes 34, 35 trouvant naturellement leur place pour venir épouser la partie des passages 148 parallèle aux axes 72.

Le feu décrit ci-dessus est un feu arrière de véhicule et ses éléments électroluminescents 3 sont ici de deux couleurs différentes à l'état allumé pour assurer notamment les fonctions stop et de changement de direction.

D'une manière générale, le transparent peut assurer une fonction optique ou ne pas assurer une telle fonction suivant les applications.

Il peut gérer le faisceau émis par l'ensemble 2, 3, 4 pour l'étaler, le redresser ou le concentrer selon les besoins.

Ce transparent peut être de couleur neutre ou fumée.

Ici, il est ambre et rouge. Il présente, figure 8, trois zones 100, 101, 102 de couleur ambre et trois parties 201, 202, 203 de couleur rouge.

Les parties 101, 102 sont disposées au sein des parties 201, 202, 203 et sont destinées à la fonction clignotant (indicateur de direction).

Les zones 201, 202, 203 sont destinées respectivement à la fonction stop, lanterne et feu anti-brouillard.

On peut allumer en même temps les trois zones 100, 101, 102 ou en différer l'allumage selon les souhaits.

De même on peut allumer une, ou plusieurs rangées de diodes par exemple en fonction de l'intensité du freinage. On peut même envoyer des messages. On appréciera que tout cela peut être réalisé avec de bonnes performances optiques, grâce à l'invention. Du fait de la configuration simple de l'élément 2 il est possible de faire varier la taille des ouvertures 22 (voir figure 7), ainsi que la forme de l'évasement de celles-ci pour avoir le meilleur éclairage possible compte tenu de la forme gauche du feu. Ici les ouvertures 22 sont des coniques de révolution; une conique étant une surface correspondant au lieu géométrique des points dont le rapport des distances à un point fixe dit foyer et à une droite dite directrice, a une valeur donnée.

On peut utiliser les dispositions décrites dans le document FR-A-2 545 195 (GB-A-2 139 340) avec des éléments à trois bornes d'alimentation. Dans ce cas trois passages 48 sont associés à chaque élément 3. On peut monter un composant tel que décrit dans le document FR-A-2 601 486 (EP-A-0 253 244). Dans ce cas la face frontale 49 porte un circuit électrique 150 (figure 2 en pointillés) le support 33 portant latéralement des bornes 134, 135. Les bornes ne traversent donc pas ici l'élément 4, seul les parties connectrices traversent ledit élément 4 comme visible dans ce document.

Le circuit 150 est dans ce cas implanté à la faveur des nervures 71. Avantageusement c'est le support 33 qui coopère ici avec les éléments 2, 4.

On peut inverser les structures par exemple l'élément 2 peut porter les nervures notamment quand on utilise des composants discrets selon le document FR-A-2.601.486 (EP-A-0 253 244), les nervures 171 repositionnent alors les diodes électroluminescentes (voir pointillés de la figure 2).

Bien entendu, selon les besoins, on peut implanter aisément d'autres composants électroniques au niveau de la face dorsale accessible de l'élément de support, tel que des composants de puissance des microprocesseurs, des composants émetteurs et/ou récepteurs d'infrarouge.

## Revendications

**1)** Feu de signalisation, notamment pour véhicule automobile, du genre comportant un élément optique de collimation (2), des éléments électroluminescents (3) comportant chacun des bornes d'alimentation (34,35) et un émetteur de lumière proprement dit (36) à semi-conducteur, un élément de support (4) pour support des éléments électroluminescents (3), ledit élément de support (4), d'une part, présentant une face frontale (49) pour pour appui des éléments électroluminescents (3) et une face dorsale (41) et, d'autre part, portant un circuit électrique d'alimentation et d'interconnexion (5) pour lesdites bornes d'alimentation (34,35), caractérisé en ce que, en combinaison, l'élément de support (4) a une forme non plane et en ce que l'élément de support (4) est conformé pour présenter des moyens de montage (70,71) suivant une même direction inclinée donnée pour les éléments électroluminescents (3).

**2)** Feu de signalisation selon la revendication 1, caractérisé en ce que lesdits moyens de montage (70,71) présentent des portées d'appui (70) perpendiculaires à une direction commune définie par des axes (72) parallèles entre eux, lesdites portées (70) étant formées sur la face frontale (49) de l'élément de support (4).

**3)** Feu de signalisation selon la revendication 2, caractérisé en ce que les axes (72) sont inclinées par rapport à une direction axiale (A) du véhicule et constituent des axes de symétrie pour lesdites portées (70).

**4)** Feu de signalisation selon la revendication 2 ou 3, caractérisé en ce que lesdites portées (70) sont parallèles entre elles.

**5)** Feu de signalisation selon l'une quelconque des revendications 2 à 4, caractérisé en ce que l'épaisseur de l'élément de support (4) varie d'une portée (70) à une autre en fonction de la forme du feu de signalisation.

**6)** Feu de signalisation selon l'une quelconque des revendications 2 à 5, caractérisé en ce que lesdits moyens de montage (70,71) comportent des nervures de positionnement (71) s'érigeant en saillie par rapport auxdites portées (70).

**7)** Feu de signalisation selon l'une quelconque des revendications 1 à 6, caractérisé en ce que lesdits éléments électroluminescents (3) sont pris en sandwich entre l'élément du support (4) et l'élément optique de collimation (2) lié audit élément de support (4) par des moyens de fixation (90).

**8)** Feu de signalisation selon la revendication 7, caractérisé en ce que la face dorsale (41) de l'élément de support (4) porte une nervure périphérique (45) plus haute que lesdites bornes (34,35), en sorte d'assurer une protection de celles-ci et du circuit électrique (5).

**9)** Feu de signalisation selon l'une quelconque des revendications 2 à 7, caractérisé en ce que des passages (48) ménagés dans l'élément de support (4), pour montage des bornes d'alimentation (34,35), sont parallèles auxdits axes (72) et débouchent au niveau des portées (70).

**10)** Feu de signalisation selon l'une quelconque des revendications 1 à 9, caractérisé en ce que l'élément de support (4) a une forme creuse et comporte une paroi périphérique ou rebord (47) délimitant le contour de cet élément de support (4) et en ce que des moyens de fixation (90) sont formés à la faveur d'un décrochement (80) formé à la périphérie externe du rebord (47).

**11)** Feu de signalisation selon la revendication 10, caractérisé en ce que lesdits moyens de fixation (90) comportent des vis venant se visser dans ledit rebord (47) à la faveur de la partie horizontale dudit décrochement (80).

**12)** Feu de signalisation selon l'une quelconque des revendications 1 à 9, caractérisé en ce que des moyens de fixation (90) comportent des tétons étagés (81) issus en saillie de l'élément de support (4), l'extrémité libre desdits tétons traversant l'élément optique de collimation (2).

**13)** Feu de signalisation selon l'une quelconque des revendications 1 à 12, caractérisé en ce que ledit circuit électrique (5) est formé par sérigraphie sur la face dorsale (41) de l'élément de support (4).

**14)** Feu de signalisation selon l'une quelconque des revendications 1 à 12, caractérisé en ce que ledit circuit électrique est formé à la faveur d'un film souple rapporté sur la face dorsale (41) de l'élément de support (4) au moyen d'une pellicule adhésive.

**15)** Feu de signalisation selon l'une quelconque des revendications 1 à 14, caractérisé en ce qu'il comporte un élément transparent (1) surplombant l'élément optique de collimation (2).

**16)** Feu de signalisation selon la revendication 15, caractérisé en ce que l'élément de support (4) est de forme creuse et présente une paroi périphérique ou rebord (47) délimitant le contour de cet élément (5) en s'érigeant vers l'extérieur et en ce que l'élément transparent (1) est de forme creuse et présente également un rebord périphérique (14) propre à coopérer avec le rebord (47) de l'élément de support (4).

**17)** Feu de signalisation selon la revendication 16, caractérisé en ce que le rebord (14) de l'élément transparent (1) est lié de manière étanche au rebord (47) de l'élément de support (4).

**18)** Feu de signalisation selon la revendication 17, caractérisé en ce que la face dorsale (41) de l'élément de support (4) porte des moyens de fixation (42,43) pour fixation du feu à la carrosserie (60) d'un véhicule.
